(19) **Europäisches Patentamt / European Patent Office / Office européen des brevets**

(11) **EP 4 130 345 A1**

(12) **EUROPEAN PATENT APPLICATION**
published in accordance with Art. 153(4) EPC

(43) Date of publication:
**08.02.2023 Bulletin 2023/06**

(21) Application number: **20928283.9**

(22) Date of filing: **21.12.2020**

(51) International Patent Classification (IPC):
**C25D 3/46** (1974.07)    **C25D 7/00** (1974.07)

(52) Cooperative Patent Classification (CPC):
**C25D 3/46; C25D 5/12; C25D 7/00; H01R 13/03**

(86) International application number:
**PCT/JP2020/047671**

(87) International publication number:
**WO 2021/199526 (07.10.2021 Gazette 2021/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2020 JP 2020061888**

(71) Applicant: **Dowa Metaltech Co., Ltd.**
**Tokyo 101-0021 (JP)**

(72) Inventors:
• **HIRAI, Yutaro**
  **Tokyo 101-0021 (JP)**
• **ARAI, Kentaro**
  **Tokyo 101-00021 (JP)**
• **SATO, Yosuke**
  **Tokyo 101-0021 (JP)**

(74) Representative: **Müller-Boré & Partner**
**Patentanwälte PartG mbB**
**Friedenheimer Brücke 21**
**80639 München (DE)**

(54) **SILVER PLATING MATERIAL, METHOD FOR PRODUCING SAME, AND TERMINAL COMPONENT**

(57)    The present invention provides a silver-plated member with a surface layer made of a silver-plating layer being formed on a base member, wherein a crystal plane of the surface layer has a { 110} plane preferential orientation, and the orientation proportion of the { 110} plane is 30% or more and 75% or less.

**EP 4 130 345 A1**

**Description**

Technical Field

The present invention relates to a silver-plated member and a method for producing the same, and more particularly to a silver-plated member that is suitable as the material of a contact or a terminal component, such as a connector, a switch or a relay, used in in-vehicle or consumer-use electric wiring, and a method for producing the same.

Background Art

Conventionally, as the material of a contact or a terminal component such as a connector or a switch, a plated member is used that is obtained by plating a base member with tin, silver, gold, or the like according to required properties such as electrical properties and solderability, the base member being a relatively inexpensive base member made of copper, a copper alloy, stainless steel, or the like and having excellent corrosion resistance, mechanical properties, and the like.

A tin-plated member obtained by plating a base member (a member to be plated) made of copper, a copper alloy, stainless steel, or the like with tin is inexpensive, but it has poor corrosion resistance in a high-temperature environment. In contrast, a gold-plated member obtained by plating a base member as described above with gold has excellent corrosion resistance and high reliability, but it requires a high cost. On the other hand, a silver-plated member obtained by plating a base member as described above with silver is less expensive than the gold-plated member, and has excellent corrosion resistance as compared with that of the tin-plated member.

Here, the material of a contact or a terminal component such as a connector or a switch is also required to have a resistance to wear caused by insertion and removal of the connector or sliding of the switch.

Accordingly, in order to improve the wear resistance of a silver-plated member, a method is known in which an element such as antimony is contained in the silver-plated member to improve the hardness of the silver-plated member (Patent Document 1).

Also, a silver-plated member is known that is obtained by forming a surface layer made of silver on a base member, wherein the silver-plated member has a reflection density of 0.3 or more, the surface layer has an Ag purity of 99.9 mass% or more, the silver-plated member has a Vickers hardness Hv of 110 or more, the Vickers hardness Hv being measured after a heat resistance test in which the silver-plated member is heated in the air at 50°C for 168 hours, and an increase in contact resistance can be prevented while maintaining a high hardness even after the heat resistance test (Patent Document 2).

Also, a silver-plated member is known that is obtained by forming a surface layer made of silver on a base member, wherein the half width of a rocking curve of a preferential orientation plane of the surface layer is 2° to 8°, the preferential orientation plane is either {200} plane or {111} plane, and the silver-plated member has good heat resistance, bending workability, and wear resistance (Patent Document 3).

Citation List

Patent Documents

Patent Document 1: JP 2009-79250A
Patent Document 2: JP 2016-204719A
Patent Document 3: JP 2014-181391A

Summary of Invention

Technical Problem

However, in the case where a contact or a terminal component such as a connector or a switch is produced using a silver-plated member with a high hardness, bending processing is usually performed during the process of producing the contact or the terminal component. At this time, the silver-plated member may be cracked to expose the base member, which may cause a reduction in the corrosion resistance of the contact or the terminal component or a breakage of the base member. Also, regarding the resistance to wear caused by insertion and removal of the connector or sliding of the switch, there is an increasing demand for the contact or the terminal component to have excellent wear resistance even when a lubricant such as a grease is not used on the sliding surface.

However, when an element such as antimony is contained in a silver-plated member as disclosed in Patent Document 1, silver is alloyed, as a result of which, a high hardness and improved wear resistance can be obtained, but the bending workability is insufficient.

Also, from the studies conducted by the inventors of the present application, it has been found that the silver-plated member of Patent Document 2 has a high hardness but insufficient bending workability, and the silver-plated member of Patent Document 3 has insufficient wear resistance.

The present invention has been made under the circumstances described above, and it is an object of the present invention to provide a silver-plated member with good bending workability and wear resistance, and a method for producing the silver-plated member.

Solution to Problem

A silver-plated member according to the present invention is a silver-plated member with a surface layer made of a silver-plating layer being formed on a base member, wherein a crystal plane of the surface layer has a { 110} plane preferential orientation, and the orientation proportion of the {110} plane is 30% or more and 75% or less.

The base member is preferably made of copper or a copper alloy, and an underlying layer made of nickel is preferably formed between the base member and the surface layer.

Also, the surface layer preferably has an average crystallite size of 45 nm or more, the silver-plated member preferably has a Vickers hardness HV of 100 or more, and the surface layer preferably has an orientation ratio { 110} / {311} of the { 110} plane to the {311} plane of 1.3 or more and 4.5 or less.

A method for producing a silver-plated member according to the present invention includes: forming a surface layer made of silver on a base member by performing electroplating in a silver plating solution made of an aqueous solution containing potassium silver cyanide at a concentration of 100 g/L or more and 160 g/L or less, potassium cyanide at a concentration 50 g/L or more and 130 g/L or less, and selenium at a concentration 20 mg/L or more and 50 mg/L or less at a current density of 1 A/dm$^2$ or more and 10 A/dm$^2$ or less and with a value obtained by dividing the concentration (g/L) of potassium silver cyanide by the current density (A/dm$^2$) being set to 25 (g·dm$^2$) / (L·A) or more and 80 (g·dm$^2$) / (L·A) or less.

The base member is preferably made of copper or a copper alloy, and an underlying nickel plating layer is preferably formed on the base member before the silver plating is performed.

Furthermore, the silver plating solution preferably contains potassium selenocyanate, and the plating solution preferably has a liquid temperature of 15°C or more and 40°C or less.

A terminal component according to the present invention is a terminal component in which the silver-plated member of the present invention described above is used as a material.

Advantageous Effects of Invention

According to the present invention, it is possible to provide a silver-plated member with good bending workability and wear resistance, and a method for producing the silver-plated member. Furthermore, it is possible to provide a terminal component with good bending workability and wear resistance by using the silver-plated member of the present invention as a material.

Description of Embodiments

The present invention provides a silver-plated member with a surface layer made of a silver-plating layer being formed on a base member, wherein a crystal plane of the surface layer has a { 110} plane preferential orientation, and the orientation proportion of the { 110} plane is 30% or more and 75% or less.

The inventors of the present application have found that a silver-plated member that has both good bending workability and good wear resistance can be provided by configuring a silver-plated member that includes a surface layer made of silver such that a crystal plane of the surface layer has a { 110} plane preferential orientation, and the orientation ratio of the {110} plane is 30% or more and 75% or less.

Hereinafter, the silver-plated member according to the present invention will be described in the following order: 1. Preferential Orientation Plane of Silver-Plating Layer (Coating Film); 2. Base Member (Member to be Plated); 3. Average Crystallite Size of Surface Layer (Silver-Plating Coating Film), 4. Vickers Hardness of Silver-Plated Member; 5. Method for Producing Silver-Plated Member; and 6. Contact or Terminal Component Obtained Using Silver-Plated Member of the Present Invention.

1. Preferential Orientation Plane of Silver-Plating Layer (Coating Film)

The surface layer that is made of a silver-plating layer (coating film) and whose crystal plane has a {110} plane preferential orientation tends to exhibit good bending workability. The reason is considered to be that the {110} plane is a crystal plane that is easily deformable in a direction in which the silver-plating coating film is deformed when the silver-plating coating film is bent. However, due to the property of being easily deformable, if the orientation proportion of the {110} plane is too high, the wear resistance may deteriorate. Accordingly, the orientation proportion of the {110} plane needs to be 30% or more and 75% or less.

Also, the surface layer preferably has an orientation ratio {110} / {311} of the {110} plane to the {311} plane of 1.3 or more and 4.5 or less. When a sample of the silver-plated member of the present invention that has a {110} plane preferential orientation is produced, it is often the case that the orientation ratio of the {311} plane is the next highest after that of the {110} plane, and the {311} plane is less deformable than the {110} plane. Accordingly, it is considered that the wear resistance tends to be improved. For this reason, in order to achieve both good bending workability and good wear resistance, the value of {110} / {311} is preferably within the above-described range. It is also preferable to set the upper limit value of {110} / {311} to 4.3 or less, and more preferably to 1.5 or more and 4.1 or less.

The crystal orientation of the surface layer of the silver-plated member is evaluated using a value (corrected intensity) obtained by correcting the peak intensity (the X-ray diffraction peak intensity) of each of a 111 diffraction peak, a 200 diffraction peak, a 220 diffraction peak, and a 311 diffraction peak of silver observed in an X-ray diffraction pattern obtained through X-ray diffractometry by dividing the peak intensity of each diffraction peak by the relative intensity ratio (the relative intensity ratio during measurement of the powder) (111:200:220:311 = 100:40:25:26) of the diffraction peaks shown in JCPDS card No. 40783. Then, the crystal plane that has an X-ray diffraction peak with the highest corrected intensity is defined as the preferential orientation plane of the surface layer (the silver-plating coating film).

In the surface layer of the silver-plated member according to the present invention, the 220 diffraction peak has the highest corrected intensity, and thus the preferential orientation plane is the {110} plane (or in other words, {110} plane preferential orientation).

The orientation proportion of the {110} plane of the present invention refers to the percentage (%) of the (X-ray diffraction) peak intensity (corrected intensity) of the 220 diffraction peak, where the sum of the corrected intensities of the (X-ray diffraction) peak intensities of the 111 diffraction peak, the 200 diffraction peak, the 220 diffraction peak, and the 311 diffraction peak of silver in the surface layer of the silver-plated member is set to 100%.

Also, the orientation ratio {110} / {311} of the {110} plane to the {311} plane of the present invention is obtained by using the corrected intensities of the (X-ray diffraction) peak intensities of the 220 diffraction peak and the 311 diffraction peak of silver in the surface layer of the silver-plated member and calculating the ratio of the peak intensity of the 220 diffraction peak to the peak intensity of the 311 diffraction peak (i.e., dividing the corrected peak intensity of the 220 diffraction peak by the corrected peak intensity of the 311 diffraction peak).

2. Base Member (Member to be Plated)

The base member (the member to be plated) is preferably made of copper or a copper alloy, and an underlying layer made of nickel is preferably formed between the base member and the surface layer. By using copper or a copper alloy as the base member, a relatively inexpensive material can be used as appropriate according to the properties such as conductivity and strength required for the contact or the terminal. Also, forming an underlying layer made of nickel such as an underlying nickel plating layer may contribute to improvement of the wear resistance.

3. Average Crystallite Size of Surface Layer (Silver-Plating Coating Film)

The surface layer (the silver-plating coating film) preferably has an average crystallite size of 45 nm or more. If the average crystallite size is too small, the crystal grains tend to be small, which may reduce workability such as bending workability. From this viewpoint, the average crystallite size is more preferably 55 nm or more, and even more preferably 63 nm or more.

However, if the average crystal grain size is too large, the hardness may decrease to reduce the wear resistance, and thus the upper limit value of the average crystallite size may be 100 nm. From this viewpoint, the upper limit value of the average crystallite size is preferably 83 nm, and more preferably 75 nm.

The average crystallite size is obtained in the following procedure.

First, the crystal orientation of the surface layer of the silver-plated member is evaluated using a value obtained by dividing the peak intensity (the X-ray diffraction peak intensity) of each of a 111 diffraction peak, a 200 diffraction peak, a 220 diffraction peak, and a 311 diffraction peak of silver observed in an X-ray diffraction pattern obtained through X-ray diffractometry by the relative intensity ratio (the relative intensity ratio during measurement of the powder) (111:200:220:311 = 100:40:25:26) of the diffraction peaks shown in JCPDS card No. 40783. This value is defined as the corrected intensity of the X-ray diffraction peak of the orientation of each crystal plane.

Next, as the orientation ratio of each of the {111} plane, the {100} plane, the {110} plane, and the {311} plane, the percentage (%) of the (X-ray diffraction) peak intensity (corrected intensity) of each of the 111 diffraction peak, the 200 diffraction peak, the 220 diffraction peak, and the 311 diffraction peak, where the sum of the corrected intensities of the (X-ray diffraction) peak intensities of the 111 diffraction peak, the 200 diffraction peak, the 220 diffraction peak, and the 311 diffraction peak of silver in the surface layer of the silver-plated member is set to 100% is obtained through calculation.

Next, the crystallite size of each of the crystal planes, including the {111} plane, the {100} plane, the {110} plane, and the {311} plane, of the surface layer (the silver-plating coating film) is calculated using the Scherrer equation from the half width of each of the peaks (the peak of the 111 diffraction peak, the peak of the 200 diffraction peak, the peak of the 220 diffraction peak, and the peak of the 311 diffraction peak of silver) observed in an X-ray diffraction pattern (an XRD pattern) obtained from an XRD diffraction apparatus, and then, the average crystallite size is determined using the following equation.

$$\text{Average crystallite size} = [\text{total of crystallite sizes of crystal planes} \times \text{orientation ratios}$$

$$(\%)\text{ of crystal planes}] / 100 \, (\%) \cdots \text{(Equation)}$$

4. Vickers Hardness of Silver-Plated Member

In order to obtain good wear resistance, the Vickers hardness (HV) of the silver-plated member is preferably 100 or more. However, when the silver-plated member is too hard, the bending workability may be reduced. Accordingly, the Vickers hardness (HV) may be 150 or less.

5. Method for Producing Silver-Plated Member

The method for producing a silver-plated member according to the present invention is characterized by forming a surface layer made of silver on a base member by performing electroplating in a silver plating solution made of an aqueous solution containing potassium silver cyanide at a concentration of 100 g/L or more and 160 g/L or less, potassium cyanide at a concentration of 50 g/L or more and 130 g/L or less, and selenium at a concentration of 20 mg/L or more and 50 mg/L or less at a current density of 1 A/dm$^2$ or more and 10 A/dm$^2$ or less and with a value obtained by dividing the concentration (g/L) of potassium silver cyanide by the current density (A/dm$^2$) being set to 25 (g·dm$^2$) / (L·A) or more and 80 (g·dm$^2$) / (L·A) or less.

When the amount of selenium is too large, it is not possible to obtain a {110} plane preferential orientation. When the amount of selenium is too small, it may not be possible to obtain a {110} plane preferential orientation. Selenium is preferably contained at a concentration of 25 mg/L or more and 45 mg/L or less. Also, it has been found that, if the value obtained by dividing the concentration of potassium silver cyanide by the current density is outside the range of 25 (g·dm$^2$) / (L·A) or more and 80 (g·dm$^2$) / (L·A), the orientation proportion of the {110} plane falls outside the range of 30% or more and 75% or less. If this value is small, it is considered that the concentration of silver in the silver plating solution relative to the current density is low, which affects the deposition of the silver plating film, and the silver plating film is unlikely to be formed on the {110} plane.

As described above, the base member is preferably made of copper or a copper alloy. Also, it is preferable to form an underlying nickel plating layer on the base member before the silver plating film is formed.

The silver plating solution may contain, as the supply source of selenium, potassium selenocyanate at a concentration of preferably 37 mg/L or more and 93 mg/L or less, and more preferably 46 mg/L or more and 83 mg/L. The liquid temperature of the plating solution is preferably set to 15°C or more and 40°C or less.

6. Contact or Terminal Component Obtained Using Silver-Plated Member of the Present Invention

The contact or the terminal component according to the present invention is characterized by the use of the silver-plated member according to the present invention as a material. By using the silver-plated member according to the present invention as a material, it is possible to provide a contact or a terminal component that has excellent bending workability and wear resistance.

Example

Hereinafter, the present invention will be described specifically with reference to examples. However, the present invention is not limited to the examples given below.

[Example 1]

(Pre-Treatment)

A 67 mm × 50 mm × 0.3 mm rolled plate made of oxygen-free copper (C1020 1/2H) was prepared as a member to be plated. As the pre-treatment of the member to be plated, the member to be plated and a SUS plate were immersed in an alkaline degreasing solution, and electrolytic degreasing was performed at a voltage of 5 V for 30 seconds using the member to be plated as the negative electrode and the SUS plate as the positive electrode. The member to be plated was washed with water, thereafter, washed in a 3% sulfuric acid for 15 seconds and washed with water.

(Underlying Nickel Plating)

Next, electroplating was performed at a current density of 5 A/dm$^2$ for 40 seconds using the member to be plated that had undergone the pre-treatment as the negative electrode and a nickel electrode plate as the positive electrode in a matte nickel plating solution made of an aqueous solution containing nickel amidosulfate tetrahydrate at a concentration of 540 g/L, nickel chloride at a concentration of 25 g/L, and boric acid at a concentration of 35 g/L by stirring the matte nickel plating solution at a liquid temperature of 55°C with a stirrer at 500 rpm.
An underlying matte nickel plating coating film with a thickness of 0.5 μm was thereby formed.

(Silver Strike Plating)

Next, electroplating was performed at a current density of 1.4 A/dm$^2$ for 10 seconds using the member to be plated on which the underlying nickel coating film was formed as the negative electrode and a platinum-coated titanium electrode plate as the positive electrode in a silver strike plating solution made of an aqueous solution containing potassium silver cyanide (KAg(CN)$_2$) at a concentration of 3 g/L and potassium cyanide (KCN) at a concentration of 90 g/L by stirring the silver strike plating solution at a liquid temperature of 25°C with a stirrer at 500 rpm. After a silver strike plating coating film was formed, the member to be plated was washed with water to sufficiently remove the silver strike plating solution.

(Silver Plating)

Next, electroplating was performed at a current density of 2 A/dm$^2$ for 330 seconds using the member to be plated on which the silver strike plating coating film was formed as the negative electrode and a silver electrode plate as the positive electrode in a silver plating solution made of an aqueous solution containing potassium silver cyanide (KAg(CN)$_2$) at a concentration of 115 g/L, potassium cyanide (KCN) at a concentration of 60 g/L, and potassium selenocyanate (KSeCN) at a concentration of 74 mg/L by stirring the silver plating solution at a liquid temperature of 25°C with a stirrer at 500 rpm. After a silver-plating coating film with a thickness of 5 μm was formed, the member to be plated was washed with water and dried to obtain a silver-plated member.
The concentration of selenium (Se) in the silver plating solution was 40 mg/L, and the value obtained by dividing the concentration of potassium silver cyanide by the current density (concentration of potassium silver cyanide /current density) was 57.5 (g·dm$^2$) / (L·A).
The conditions for manufacturing the silver-plated member described above are shown in Table 1.

(Preferential Orientation Plane)

In order to determine the crystal orientation of the surface layer of the silver-plated member, an X-ray diffraction pattern was obtained according to the Kβ filter method using a Cu tube in an X-ray diffraction analysis apparatus (fully automated multipurpose horizontal X-ray diffraction apparatus Smart Lab available from Rigaku Corporation) with the scan range being set to 2θ to 5° to 120° and the scan speed being set to 50 deg/min. Then, the peak intensity (the X-ray diffraction peak intensity) of each of a 111 diffraction peak observed at around 38°, a 200 diffraction peak observed at around 44°, a 220 diffraction peak observed at around 64°, and a 311 diffraction peak observed at around 77° of silver (the plating coating film) in the X-ray diffraction pattern was corrected by dividing the peak intensity (the X-ray diffraction peak intensity) of each of the 111 diffraction peak, the 200 diffraction peak, the 220 diffraction peak, and the 311 diffraction peak by the relative intensity ratio (the relative intensity ratio during measurement of the powder) (111:200:220:311 = 100:40:25:26) of the diffraction peaks shown in JCPDS card No. 40783 to obtain a value (corrected intensity), and the crystal plane that had an X-ray diffraction peak with the highest corrected value (corrected intensity) was defined as the preferential orientation plane of the silver-plating coating film.

As a result, it was found that the corrected intensity of the 220 diffraction peak was highest among the X-ray diffraction peaks of the silver-plating coating film, or in other words, the {110} plane was preferentially oriented in the surface (plate surface) of the silver-plated member. Accordingly, the crystal plane of the surface layer (the silver-plating coating film) had a {110} plane preferential orientation (here, the {110} plane is used rather than the {220} plane because the crystal plane is supposed to be indicated by the smallest integer ratio).

Also, the orientation proportion of the {110} plane of the surface layer of the silver-plated member is obtained by calculating the proportion (percentage) of the (X-ray diffraction) peak intensity (corrected intensity) of the 220 diffraction peak, where the sum of the corrected intensities of the X-ray diffraction peak intensities of the 111 diffraction peak, the 200 diffraction peak, the 220 diffraction peak, and the 311 diffraction peak was set to 100%. The thus-obtained orientation proportion of the {110} plane of the surface layer was 57.0%.

Also, the orientation ratio {110} / {311} of the {110} plane to the {311} plane of the surface layer of the silver-plated member was obtained by using the corrected intensities of the (X-ray diffraction) peak intensities of the 220 diffraction peak and the 311 diffraction peak of silver in the surface layer of the silver-plated member and calculating the ratio of the peak intensity of the 220 diffraction peak to the peak intensity of the 311 diffraction peak (corrected intensity of 220 diffraction peak / corrected intensity of 311 diffraction peak). As a result, the orientation ratio {110} / {311} of the {110} plane to the {311} plane of the surface layer of the silver-plated member was 2.5.

(Average Crystallite Size)

The average crystallite size was obtained in the following procedure.

First, the crystal orientation of the surface layer of the silver-plated member was evaluated using a value obtained by dividing the peak intensity (the X-ray diffraction peak intensity) of each of the X-ray diffraction peaks of the crystal planes of silver (a 111 diffraction peak observed at around 38°, a 200 diffraction peak observed at around 44°, a 220 diffraction peak observed at around 64°, and a 311 diffraction peak observed at around 77°) observed in an X-ray diffraction pattern (an XRD pattern) obtained using an XRD analysis apparatus (fully automated multipurpose horizontal X-ray diffraction apparatus Smart Lab available from Rigaku Corporation) by 100, 40, 25, or 26 obtained from the relative intensity ratio (the relative intensity ratio during measurement of the powder) (111:200:220:311 = 100:40:25:26) of the diffraction peaks shown in JCPDS card No. 40783. This value was defined as the corrected intensity of the X-ray diffraction peak of the orientation of each crystal plane.

Next, the orientation ratio of each of the {111} plane, the {100} plane, the {110} plane, and the {311} plane was obtained by calculating the proportion (percentage, %) of the (X-ray diffraction) peak intensity (corrected intensity) of each of the 111 diffraction peak, the 200 diffraction peak, the 220 diffraction peak, and the 311 diffraction peak, where the sum of the corrected intensities of the (X-ray diffraction) peak intensities of the 111 diffraction peak, the 200 diffraction peak, the 220 diffraction peak, and the 311 diffraction peak of silver of the surface layer of the silver-plated member was set to 100%.

Next, the crystallite size of each of the crystal planes (the {111} plane, the {100} plane, the {110} plane, and the {311} plane) of the surface layer (the silver-plating coating film) was calculated using the Scherrer equation from the half width of each of the X-ray diffraction peaks of the crystal planes of silver (a 111 diffraction peak observed at around 38°, a 200 diffraction peak observed at around 44°, a 220 diffraction peak observed at around 64°, and a 311 diffraction peak observed at around 77°) in an X-ray diffraction pattern (an XRD pattern) obtained using an XRD analysis apparatus (fully automated multipurpose horizontal X-ray diffraction apparatus Smart Lab available from Rigaku Corporation). Then, the average crystallite size was determined using the following equation.

$$\text{Average crystallite size} = [(\text{crystallite size of } \{111\} \text{ crystal plane} \times \text{orientation ratio (\%) of } \{111\} \text{ crystal plane}) + (\text{crystallite size of } \{100\} \text{ crystal plane} \times \text{orientation ratio (\%) of } \{100\} \text{ crystal plane}) + (\text{crystallite size of } \{110\} \text{ crystal plane} \times \text{orientation ratio (\%) of } \{110\} \text{ crystal plane}) + (\text{crystallite size of } \{311\} \text{ crystal plane} \times \text{orientation ratio (\%) of } \{311\} \text{ crystal plane})] / 100(\%) \dots \text{(Equation)}$$

As a result, the average crystallite size of the silver-plating coating film was 56.68 nm (566.8 angstrom).

(Wear Resistance)

Wear resistance evaluation was performed by performing a wear test in the following manner. Two silver-plated members obtained in the manner described above were prepared. One of the two silver-plated members was subjected to indentation processing (inner R = 1.5 mm) and used as an indenter, and the other silver-plated member was used as a flat plate-like evaluation sample. Using a precision sliding test apparatus (CRS-G2050-DWS available from Yamasaki Seiki Laboratory), a back-and-forth sliding operation (with a slide distance of 5 mm and a slide speed of 1.67 mm/s) was continuously performed, with the indenter being pressed against the evaluation sample at a fixed load (5N), until the base member was exposed. Then, the center portion of a slide mark of the silver-plated member was observed using a microscope (VHX-1000 available from Keyence Corporation) at a magnification of 100 every ten times the back-and-forth sliding operation was performed to check the wear state of the silver-plated member.

As a result, it was confirmed that the base member was not exposed after the sliding operation of was performed 40 times, from which it was found that the silver-plated member had excellent wear resistance.

(Bending Test)

A silver-plated member obtained in the manner described above was prepared. The silver-plated member was evaluated by bending the silver-plated member at an inner R of 1 mm using a bending testing jig (SCHMIDT Presse available from Nakaseiki Co., Ltd.) and observing the surface of the bent portion (mountain fold) using the above-described microscope at a magnification of 500 to determine whether an exposure of the base member could be found. As a result, an exposure of the base member was not found even at R = 1 mm, from which it was found that the silver-plated member had excellent bending workability.

(Vickers hardness)

The Vickers hardness HV of the surface of the silver-plated member was measured in accordance with JIS Z2244 by applying a measurement load of 10 gf for 10 seconds using a micro hardness tester (HM-221 available from Mitutoyo Corporation). As a result, the Vickers hardness HV was 124.3.

(Reflection Density)

As the gloss level of the silver-plated member, the reflection density of the silver-plated member was measured in parallel to the rolling direction of the base member using a concentration meter (densitometer ND-1 available from Nippon Denshoku Industries Co., Ltd.). As a result, the reflection density was 0.03.

The properties of the silver-plating coating film and the evaluation results of the silver-plated member described above are shown in Table 2.

In Table 2, the bending workability is indicated by a circle (○) when an exposure of the base member was not observed (excellent bending workability) and a cross (×) when an exposure of the base member was observed (poor bending workability) in the observation of the surface of the bent portion described above.

[Example 2]

A silver-plated member was produced in the same manner as in Example 1, except that a silver-plating coating film was formed in a silver plating solution made of an aqueous solution containing potassium cyanide (KCN) at a concentration of 120 g/L.

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio { 110} / {311} of the { 110} plane to the {311} plane, and the average crystallite size of the surface layer, and the wear resistance, the bending workability, the Vickers hardness, and the reflection density in the same manner as in Example 1.

As a result, the silver-plating coating film had a { 110} preferential orientation, the orientation proportion of the {110} plane was 41.1%, the orientation ratio {110} / {311} was 1.7, and the average crystallite size was 60.85 nm (608.5 angstrom). Also, an exposure of the base member was not observed after the sliding operation was performed 40 times, from which it can be seen that the wear resistance is excellent. Also, an exposure of the base member was not observed in the bending test, from which it can be seen that the bending workability is excellent. Also, the Vickers hardness HV was 110.8, and the reflection density was 0.02.

The properties of the silver-plating coating film and the evaluation results of the silver-plated member described above are shown in Table 2.

[Example 3]

A silver-plated member was produced in the same manner as in Example 1, except that a silver-plating coating film was formed in a silver plating solution made of an aqueous solution containing potassium silver cyanide (KAg(CN)$_2$) at a concentration of 148 g/L.

The value obtained by dividing the concentration of potassium silver cyanide by the current density (concentration of potassium silver cyanide /current density) was 74.0 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 36.2%, the orientation ratio {110} / {311} was 1.4, and the average crystallite size was 65.70 nm (657.0 angstrom). Also, an exposure of the base member was not observed after the sliding operation was performed 40 times, from which it can be seen that the wear resistance is excellent. Also, an exposure of the base member was not observed in the bending test, from which it can be seen that the bending workability is excellent. Also, the Vickers hardness HV was 130.1, and the reflection density was 0.04.

The properties of the silver-plating coating film and the evaluation results of the silver-plated member described above are shown in Table 2.

[Example 4]

A silver-plated member was produced in the same manner as in Example 1, except that a silver-plating coating film was formed in a silver plating solution made of an aqueous solution containing potassium silver cyanide (KAg(CN)$_2$) at a concentration of 148 g/L and potassium cyanide (KCN) at a concentration of 120 g/L.

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 41.1 %, the orientation ratio {110} / {311} was 1.8, and the average crystallite size was 62.10 nm (621.0 angstrom). Also, an exposure of the base member was not observed after the sliding operation was performed 40 times, from which it can be seen that the wear resistance is excellent. Also, an exposure of the base member was not observed in the bending test, from which it can be seen that the bending workability is excellent. Also, the Vickers hardness HV was 116.2, and the reflection density was 0.02.

The properties of the silver-plating coating film and the evaluation results of the silver-plated member described above are shown in Table 2.

[Example 5]

A silver-plated member was produced in the same manner as in Example 3, except that a silver-plating coating film was formed by performing electroplating at a current density of 5 A/dm$^2$ for 130 seconds.

The concentration of selenium (Se) in the silver plating solution was 40 mg/L, and the value obtained by dividing the concentration of potassium silver cyanide by the current density (concentration of potassium silver cyanide /current density) was 29.6 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 47.3%, the orientation ratio {110} / {311} was 2.2, and the average crystallite size was 50.74 nm (507.4 angstrom). Also, an exposure of the base member was not observed after the sliding operation was performed 40 times, from which it can be seen that the wear resistance is excellent. Also, an exposure of the base member was not observed in the bending test, from which it can be seen that the bending workability is excellent. Also, the Vickers hardness HV was 108.5, and the reflection density was 0.06.

The properties of the silver-plating coating film and the evaluation results of the silver-plated member described above are shown in Table 2.

[Example 6]

A silver-plated member was produced in the same manner as in Example 1, except that a silver-plating coating film was formed by performing electroplating at a liquid temperature of 30°C.

The concentration of selenium (Se) in the silver plating solution was 40 mg/L, and the value obtained by dividing the concentration of potassium silver cyanide by the current density (concentration of potassium silver cyanide /current density) was 57.5 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 67.4%, the orientation ratio {110} / {311} was 3.7, and the average crystallite size was 64.28 nm (642.8 angstrom). Also, an exposure of the base member was not observed after the sliding operation was performed 50 times, from which it can be seen that the wear resistance is excellent. Also, an exposure of the base member was not observed in the bending test, from which it can be seen that the bending workability is excellent. Also, the Vickers hardness HV was 117.6, and the reflection density was 0.01.

The properties of the silver-plating coating film and the evaluation results of the silver-plated member described above are shown in Table 2.

[Example 7]

A silver-plated member was produced in the same manner as in Example 2, except that a silver-plating coating film was formed by performing electroplating at a liquid temperature of 30°C.

The concentration of selenium (Se) in the silver plating solution was 40 mg/L, and the value obtained by dividing the concentration of potassium silver cyanide by the current density (concentration of potassium silver cyanide /current density) was 57.5 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 38.1 %, the orientation ratio {110} / {311} was 1.6, and the average crystallite size was 68.64 nm (686.4 angstrom). Also, an exposure of the base member was not observed after the sliding operation was performed 50 times, from which it can be seen that the wear resistance is excellent. Also, an exposure of the base member was not observed in the bending test, from which it can be seen that the bending workability is excellent. Also, the Vickers hardness HV was 118.2, and the reflection density was 0.03.

The properties of the silver-plating coating film and the evaluation results of the silver-plated member described above are shown in Table 2.

[Example 8]

A silver-plated member was produced in the same manner as in Example 7, except that a silver-plating coating film was formed in a silver plating solution made of an aqueous solution containing potassium silver cyanide at a concentration of 148 g/L.

The concentration of selenium (Se) in the silver plating solution was 40 mg/L, and the value obtained by dividing the concentration of potassium silver cyanide by the current density (concentration of potassium silver cyanide /current density) was 74.0 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio { 110} / {311} of the { 110} plane to the {311} plane, the average crystallite size, the wear resistance, the bending workability, the Vickers hardness, and the reflection density of the surface layer in the same manner as in Example 1.

As a result, the silver-plating coating film had a { 110} preferential orientation, the orientation proportion of the {110} plane was 46.7%, the orientation ratio {110} / {311} was 2.2, and the average crystallite size was 68.96 nm (689.6 angstrom). Also, an exposure of the base member was not observed after the sliding operation was performed 60 times, from which it can be seen that the wear resistance is excellent. Also, an exposure of the base member was not observed in the bending test, from which it can be seen that the bending workability is excellent. Also, the Vickers hardness HV was 127.7, and the reflection density was 0.02.

The properties of the silver-plating coating film and the evaluation results of the silver-plated member described above are shown in Table 2.

[Example 9]

A silver-plated member was produced in the same manner as in Example 5, except that a silver-plating coating film was formed by performing electroplating at a liquid temperature of 30°C.

The concentration of selenium (Se) in the silver plating solution was 40 mg/L, and the value obtained by dividing the concentration of potassium silver cyanide by the current density (concentration of potassium silver cyanide /current density) was 29.6 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio {110} / {311} of the { 110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 46.7%, the orientation ratio {110} / {311} was 2.0, and the average crystallite size was 55.62 nm (556.2 angstrom). Also, an exposure of the base member was not observed after the sliding operation was performed 40 times, from which it can be seen that the wear resistance is excellent. Also, an exposure of the base member was not observed in the bending test, from which it can be seen that the bending workability is excellent. Also, the Vickers hardness HV was 108.6, and the reflection density was 0.04.

The properties of the silver-plating coating film and the evaluation results of the silver-plated member described above are shown in Table 2.

[Example 10]

A silver-plated member was produced in the same manner as in Example 9, except that a silver-plating coating film was formed in a silver plating solution made of an aqueous solution containing potassium cyanide at a concentration of 120 g/L.

The concentration of selenium (Se) in the silver plating solution was 40 mg/L, and the value obtained by dividing the concentration of potassium silver cyanide by the current density (concentration of potassium silver cyanide /current density) was 29.6 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio {110} / {311} of the { 110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 71.3%, the orientation ratio {110} / {311} was 4.1, and the average crystallite size was 46.50 nm (465.0 angstrom). Also, an exposure of the base member was not observed after the sliding operation was performed 40 times, from which it can be seen that the wear resistance is excellent. Also, an exposure of the base member was not observed in the bending test, from which it can be seen that the bending workability is excellent. Also, the Vickers hardness HV was 118.3, and the reflection density was 0.21.

The properties of the silver-plating coating film and the evaluation results of the silver-plated member described above are shown in Table 2.

[Example 11]

A silver-plated member was produced in the same manner as in Example 2, except that a silver-plating coating film was formed in a silver plating solution made of an aqueous solution containing potassium selenocyanate (KSeCN) at a concentration of 56 mg/L.

The concentration of selenium (Se) in the silver plating solution was 30 mg/L, and the value obtained by dividing the concentration of potassium silver cyanide by the current density (concentration of potassium silver cyanide /current density) was 57.5 $(g \cdot dm^2)$ / $(L \cdot A)$.

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 48.5%, the orientation ratio {110} / {311} was 2.2, and the average crystallite size was 59.42 nm (594.2 angstrom). Also, an exposure of the base member was not observed after the sliding operation was performed 40 times, from which it can be seen that the wear resistance is excellent. Also, an exposure of the base member was not observed in the bending test, from which it can be seen that the bending workability is excellent. Also, the Vickers hardness HV was 114.1, and the reflection density was 0.05.

The properties of the silver-plating coating film and the evaluation results of the silver-plated member described above are shown in Table 2.

[Example 12]

A silver-plated member was produced in the same manner as in Example 6, except that a silver-plating coating film was formed in a silver plating solution made of an aqueous solution containing potassium selenocyanate (KSeCN) at a concentration of 56 mg/L.

The concentration of selenium (Se) in the silver plating solution was 30 mg/L, and the value obtained by dividing the concentration of potassium silver cyanide by the current density (concentration of potassium silver cyanide /current density) was 57.5 $(g \cdot dm^2)$ / $(L \cdot A)$.

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 54.7%, the orientation ratio {110} / {311} was 4.0, and the average crystallite size was 59.61 nm (596.1 angstrom). Also, an exposure of the base member was not observed after the sliding operation was performed 40 times, from which it can be seen that the wear resistance is excellent. Also, an exposure of the base member was not observed in the bending test, from which it can be seen that the bending workability is excellent. Also, the Vickers hardness HV was 107.7, and the reflection density was 0.05.

The properties of the silver-plating coating film and the evaluation results of the silver-plated member described above are shown in Table 2.

[Comparative Example 1]

A silver-plated member was produced in the same manner as in Example 2, except that a silver-plating coating film was formed in a silver plating solution made of an aqueous solution containing potassium silver cyanide at a concentration of 111 g/L and potassium selenocyanate at a concentration of 24 mg/L.

The concentration of selenium (Se) in the silver plating solution was 13 mg/L, and the value obtained by dividing the concentration of potassium silver cyanide by the current density (concentration of potassium silver cyanide /current density) was 55.5 $(g \cdot dm^2)$ / $(L \cdot A)$.

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 80.3%, the orientation ratio {110} / {311} was 6.3, and the average crystallite size was 51.00 nm (510.0 angstrom). Also, an exposure of the base member was observed after the sliding operation was performed 40 times (an exposure of the base member was not observed after the sliding operation was performed 30 times), from which it can be seen that the wear resistance is poor. Also, an exposure of the base member was not observed in the bending test, from which it can be seen that the bending workability is excellent. Also, the Vickers hardness HV was 104.3, and the reflection density was 0.07.

The properties of the silver-plating coating film and the evaluation results of the silver-plated member described above are shown in Table 2.

[Comparative Example 2]

A silver-plated member was produced in the same manner as in Comparative Example 1, except that a silver-plating coating film was formed by performing electroplating at a current density of 5 A/dm$^2$ for 130 seconds.

The concentration of selenium (Se) in the silver plating solution was 13 mg/L, and the value obtained by dividing the concentration of potassium silver cyanide by the current density (concentration of potassium silver cyanide /current density) was 22.2 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {111} preferential orientation, the orientation proportion of the {110} plane was 6.9%, the orientation ratio {110} / {311} was 0.3, and the average crystallite size was 31.48 nm (314.8 angstrom). Also, an exposure of the base member was observed after the sliding operation was performed 40 times (an exposure of the base member was not observed after the sliding operation was performed 30 times), from which it can be seen that the wear resistance is poor. Also, an exposure of the base member was not observed in the bending test, from which it can be seen that the bending workability is excellent. Also, the Vickers hardness HV was 118.3, and the reflection density was 1.51.

The properties of the silver-plating coating film and the evaluation results of the silver-plated member described above are shown in Table 2.

[Comparative Example 3]

A silver-plated member was produced in the same manner as in Example 1, except that a silver-plating coating film was formed by performing electroplating at a current density of 5 A/dm$^2$ for 130 seconds.

The concentration of selenium (Se) in the silver plating solution was 40 mg/L, and the value obtained by dividing the concentration of potassium silver cyanide by the current density (concentration of potassium silver cyanide /current density) was 23.0 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio { 110} / {311} of the { 110} plane to the {311} plane, the average crystallite size, the wear resistance, the bending workability, the Vickers hardness, and the reflection density of the surface layer in the same manner as in Example 1.

As a result, the silver-plating coating film had a { 110} preferential orientation, the orientation proportion of the {110} plane was 78.3%, the orientation ratio {110} / {311} was 11.5, and the average crystallite size was 42.82 nm (428.2 angstrom). Also, an exposure of the base member was observed after the sliding operation was performed 40 times (an exposure of the base member was not observed after the sliding operation was performed 30 times), from which it can be seen that the wear resistance is poor. Also, an exposure of the base member was not observed in the bending test, from which it can be seen that the bending workability is excellent. Also, the Vickers hardness HV was 125.4, and the reflection density was 0.15.

The properties of the silver-plating coating film and the evaluation results of the silver-plated member described above are shown in Table 2.

[Comparative Example 4]

A silver-plated member was produced in the same manner as in Comparative Example 3, except that a silver-plating coating film was formed in a silver plating solution made of an aqueous solution containing potassium cyanide at a concentration of 120 g/L.

The concentration of selenium (Se) in the silver plating solution was 40 mg/L, and the value obtained by dividing the concentration of potassium silver cyanide by the current density (concentration of potassium silver cyanide /current density) was 23.0 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio { 110} / {311} of the { 110} plane to the {311} plane, the average crystallite size, the wear resistance, the bending workability, the Vickers hardness, and the reflection density of the surface layer in the same manner as in Example 1.

As a result, the silver-plating coating film had a {111} preferential orientation, the orientation proportion of the f 110} plane was 9.8%, the orientation ratio {110} / {311} was 0.5, and the average crystallite size was 32.03 nm (320.3 angstrom). Also, an exposure of the base member was not observed after the sliding operation was performed 70 times, from which it can be seen that the wear resistance is excellent. However, an exposure of the base member was observed in the bending test, from which it can be seen that the bending workability is poor. Also, the Vickers hardness HV was 129.0, and the reflection density was 1.56.

The properties of the silver-plating coating film and the evaluation results of the silver-plated member described above are shown in Table 2.

[Comparative Example 5]

A silver-plated member was produced in the same manner as in Example 6, except that a silver-plating coating film was formed by performing electroplating at a current density of 5 A/dm$^2$ for 130 seconds.

The concentration of selenium (Se) in the silver plating solution was 40 mg/L, and the value obtained by dividing the concentration of potassium silver cyanide by the current density (concentration of potassium silver cyanide /current density) was 23.0 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio { 110} / {311} of the { 110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 81.1%, the orientation ratio {110} / {311} was 7.0, and the average crystallite size was 50.21 nm (502.1 angstrom). Also, an exposure of the base member was observed after the sliding operation was performed 40 times (an exposure of the base member was not observed after the sliding operation was performed 30 times), from which it can be seen that the wear resistance is poor. Also, an exposure of the base member was not observed in the bending test, from which it can be seen that the bending workability is excellent. Also, the Vickers hardness HV was 109.7, and the reflection density was 0.04.

The properties of the silver-plating coating film and the evaluation results of the silver-plated member described above are shown in Table 2.

[Comparative Example 6]

A silver-plated member was produced in the same manner as in Comparative Example 5, except that a silver-plating coating film was formed in a silver plating solution made of an aqueous solution containing potassium cyanide at a concentration of 120 g/L.

The concentration of selenium (Se) in the silver plating solution was 40 mg/L, and the value obtained by dividing the concentration of potassium silver cyanide by the current density (concentration of potassium silver cyanide /current density) was 23.0 (g·dm$^2$) / (L·A).

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio {110} / {311} of the { 110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 76.2%, the orientation ratio {110} / {311} was 4.6, and the average crystallite size was 43.66 nm (436.6 angstrom). Also, an exposure of the base member was observed after the sliding operation was performed 40 times (an exposure of the base member was not observed after the sliding operation was performed 30 times), from which it can be seen that the wear resistance is poor. An exposure of the base member was not observed in the bending test, from which it can be seen that the bending workability is excellent. Also, the Vickers hardness HV was 110.3, and the reflection density was 0.16.

The properties of the silver-plating coating film and the evaluation results of the silver-plated member described above are shown in Table 2.

[Comparative Example 7]

A silver-plated member was produced in the same manner as in Example 1, except that a silver-plating coating film was formed by performing electroplating at a liquid temperature of 16°C and a current density of 8 A/dm² for 80 seconds in a silver plating solution made of an aqueous solution containing potassium silver cyanide at a concentration of 148 g/L, potassium cyanide at a concentration of 140 g/L, and potassium selenocyanate at a concentration of 15 mg/L.

The concentration of selenium (Se) in the silver plating solution was 8 mg/L, and the value obtained by dividing the concentration of potassium silver cyanide by the current density (concentration of potassium silver cyanide /current density) was 18.5 (g·dm²) / (L·A).

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio { 110} / {311} of the { 110} plane to the {311} plane, the average crystallite size, the wear resistance, the bending workability, the Vickers hardness, and the reflection density of the surface layer in the same manner as in Example 1.

As a result, the silver-plating coating film had a { 100} preferential orientation, the orientation proportion of the { 110} plane was 0.0%, the orientation ratio { 110} / {311} was 0.0, and the average crystallite size was 84.69 nm (846.9 angstrom). Also, an exposure of the base member was observed after the sliding operation was performed 40 times (an exposure of the base member was not observed after the sliding operation was performed 30 times), from which it can be seen that the wear resistance is poor. Also, an exposure of the base member was not observed in the bending test, from which it can be seen that the bending workability is excellent. Also, the Vickers hardness HV was 89.7, and the reflection density was 1.34.

The properties of the silver-plating coating film and the evaluation results of the silver-plated member described above are shown in Table 2.

[Comparative Example 8]

A silver-plated member was produced in the same manner as in Example 1, except that a silver-plating coating film was formed by performing electroplating at a liquid temperature of 18°C and a current density of 5 A/dm² for 130 seconds in a silver plating solution made of an aqueous solution containing potassium silver cyanide at a concentration of 175 g/L, potassium cyanide at a concentration of 95 g/L, and potassium selenocyanate at a concentration of 130 mg/L.

The concentration of selenium (Se) in the silver plating solution was 70 mg/L, and the value obtained by dividing the concentration of potassium silver cyanide by the current density (concentration of potassium silver cyanide /current density) was 35.0 (g·dm²) / (L·A).

The conditions for manufacturing the silver-plated member described above are shown in Table 1.

The thus-obtained silver-plated member was subjected to measurement and evaluation for the preferential orientation plane, the orientation proportion of the { 110} plane, the orientation ratio {110} / {311} of the { 110} plane to the {311} plane, the average crystallite size, the wear resistance, the bending workability, the Vickers hardness, and the reflection density of the surface layer in the same manner as in Example 1.

As a result, the silver-plating coating film had a {111} preferential orientation, the orientation proportion of the {110} plane was 7.9%, the orientation ratio {110} / {311} was 0.3, and the average crystallite size was 28.14 nm (281.4 angstrom). Also, an exposure of the base member was not observed after the sliding operation was performed 50 times, from which it can be seen that the wear resistance is excellent. However, an exposure of the base member was observed in the bending test, from which it can be seen that the bending workability is poor. Also, the Vickers hardness HV was 125.9, and the reflection density was 1.56.

The properties of the silver-plating coating film and the evaluation results of the silver-plated member described above are shown in Table 2.

[Comparative Example 9]

A silver-plated member was produced in the same manner as in Example 12, except that a silver-plating coating film was formed by performing electroplating at a current density of 5 A/dm² for 130 seconds in a silver plating solution made of an aqueous solution containing potassium cyanide at a concentration of 120 g/L.

The concentration of selenium (Se) in the silver plating solution was 30 mg/L, and the value obtained by dividing the concentration of potassium silver cyanide by the current density (concentration of potassium silver cyanide /current density) was 23.0 (g·dm²) / (L·A).

The conditions for manufacturing the silver-plated member described above are shown in Table 1.

The thus-obtained silver-plated member was subjected to measurement and evaluation for the preferential orientation plane, the orientation proportion of the {110} plane, the orientation ratio {110} / {311} of the {110} plane to the {311} plane, the average crystallite size, the wear resistance, the bending workability, the Vickers hardness, and the reflection density of the surface layer in the same manner as in Example 1.

As a result, the silver-plating coating film had a {110} preferential orientation, the orientation proportion of the {110} plane was 80.5%, the orientation ratio {110} / {311} was 6.7, and the average crystallite size was 31.09 nm (310.9 angstrom). Also, an exposure of the base member was observed after the sliding operation was performed 40 times (an exposure of the base member was not observed after the sliding operation was performed 30 times), from which it can be seen that the wear resistance is poor. Also, an exposure of the base member was observed in the bending test, from which it can be seen that the bending workability is also poor. Also, the Vickers hardness HV was 117.5, and the reflection density was 0.27.

The properties of the silver-plating coating film and the evaluation results of the silver-plated member described above are shown in Table 2.

[Conclusion]

In the silver-plated members of Examples of the present invention, an exposure of the base member was not observed at the bent portion in the bending test performed at an inner R of 1 mm, and an exposure of the base member was not observed after the sliding operation was performed 40 times in the wear test, from which it can be seen that the silver-plated members of Examples have good properties. In contrast, in the silver-plated members of Comparative Examples, an exposure of the base member was observed in either one of the bending test and the wear test. Accordingly, when the silver-plated members are used as contacts or terminal members, there may be a possibility of the occurrence of a failure.

In addition, silver purity was determined through plasma spectroscopy analysis using an ICP emission spectroscopy analysis (ICP-OES) apparatus (SPS 5100 available from Seiko Instruments Inc.) by adjusting the concentration of a solution prepared by dissolving the silver-plating coating film of each of the silver-plated members of Examples and Comparative Examples in nitric acid. As a result, in all of Examples and Comparative Examples, the silver-plated members had a silver purity of 99.9 mass% or more.

[Table 1]

| | Conditions for manufacturing silver-plated member | | | | | | | |
|---|---|---|---|---|---|---|---|---|
| | $K[Ag(CN)_2]$ | KCN | KSeCN | Se | Liquid temperature | Current density | $K[Ag(CN)_2]$ concentration / current density | Silver plating time |
| | [g/L] | [g/L] | [mg/L] | [mg/L] | [°C] | [A/dm²] | [(g·dm²)]/(L·A)] | [s] |
| Example 1 | 115 | 60 | 74 | 40 | 25 | 2 | 57.5 | 330 |
| Example 2 | 115 | 120 | 74 | 40 | 25 | 2 | 57.5 | 330 |
| Example 3 | 148 | 60 | 74 | 40 | 25 | 2 | 74 | 330 |
| Example 4 | 148 | 120 | 74 | 40 | 25 | 2 | 74 | 330 |
| Example 5 | 148 | 60 | 74 | 40 | 25 | 5 | 29.6 | 130 |
| Example 6 | 115 | 60 | 74 | 40 | 30 | 2 | 57.5 | 330 |
| Example 7 | 115 | 120 | 74 | 40 | 30 | 2 | 57.5 | 330 |
| Example 8 | 148 | 120 | 74 | 40 | 30 | 2 | 74 | 330 |
| Example 9 | 148 | 60 | 74 | 40 | 30 | 5 | 29.6 | 130 |

(continued)

| | Conditions for manufacturing silver-plated member | | | | | | | |
|---|---|---|---|---|---|---|---|---|
| | K[Ag(CN)2] | KCN | KSeCN | Se | Liquid temperature | Current density | K[Ag(CN)$_2$] concentration / current density | Silver plating time |
| | [g/L] | [g/L] | [mg/L] | [mg/L] | [°C] | [A/dm$^2$] | [(g·dm$^2$)/(L·A)] | [s] |
| Example 10 | 148 | 120 | 74 | 40 | 30 | 5 | 29.6 | 130 |
| Example 11 | 115 | 120 | 56 | 30 | 25 | 2 | 57.5 | 330 |
| Example 12 | 115 | 60 | 56 | 30 | 30 | 2 | 57.5 | 330 |
| Comp. Ex. 1 | 111 | 120 | 24 | 13 | 25 | 2 | 55.5 | 330 |
| Comp. Ex. 2 | 111 | 120 | 24 | 13 | 25 | 5 | 22.2 | 130 |
| Comp. Ex. 3 | 115 | 60 | 74 | 40 | 25 | 5 | 23 | 130 |
| Comp. Ex. 4 | 115 | 120 | 74 | 40 | 25 | 5 | 23 | 130 |
| Comp. Ex. 5 | 115 | 60 | 74 | 40 | 30 | 5 | 23 | 130 |
| Comp. Ex. 6 | 115 | 120 | 74 | 40 | 30 | 5 | 23 | 130 |
| Comp. Ex. 7 | 148 | 140 | 15 | 8 | 16 | 8 | 18.5 | 80 |
| Comp. Ex. 8 | 175 | 95 | 130 | 70 | 18 | 5 | 35 | 130 |
| Comp. Ex. 9 | 115 | 120 | 56 | 30 | 30 | 5 | 23 | 130 |

[Table 2]

| | Silver-plating coating film | | | | | Evaluation results of silver-plated member | | | |
|---|---|---|---|---|---|---|---|---|---|
| | Thickness of silver-plating coating film | Preferential orientation plane | Orientation proportion of {110} plane | Orientation ratio {110} / {311} | Crystallite size | Vickers hardness | Bending workability R = 1 mm | Durability in sliding test | Reflection density |
| | [μm] | | [%] | | [Å] | | | [times] | |
| Example 1 | 5 | {110} | 57.0 | 2.5 | 566.8 | 124.3 | ○ | 40 | 0.03 |
| Example 2 | 5 | {110} | 41.1 | 1.7 | 608.5 | 110.8 | ○ | 40 | 0.02 |
| Example 3 | 5 | {110} | 36.2 | 1.4 | 657.0 | 130.1 | ○ | 40 | 0.04 |
| Example 4 | 5 | {110) | 41.1 | 1.8 | 621.0 | 116.2 | ○ | 40 | 0.02 |
| Example 5 | 5 | {110} | 47.3 | 2.2 | 507.4 | 108.5 | ○ | 40 | 0.06 |
| Example 6 | 5 | {110} | 67.4 | 3.7 | 642.8 | 117.6 | ○ | 50 | 0.01 |
| Example 7 | 5 | {110} | 38.1 | 1.6 | 686.4 | 118.2 | ○ | 50 | 0.03 |
| Example 8 | 5 | {110} | 46.7 | 2.2 | 689.6 | 127.7 | ○ | 60 | 0.02 |
| Example 9 | 5 | {110} | 46.7 | 2.0 | 556.2 | 108.6 | ○ | 40 | 0.04 |
| Example 10 | 5 | {110} | 71.3 | 4.1 | 465.0 | 118.3 | ○ | 40 | 0.21 |
| Example 11 | 5 | {110} | 48.5 | 2.2 | 594.2 | 114.1 | ○ | 40 | 0.05 |
| Example 12 | 5 | {110} | 54.7 | 4.0 | 596.1 | 107.7 | ○ | 40 | 0.05 |
| Comp. Ex. 1 | 5 | {110} | 80.3 | 6.3 | 510.0 | 104.3 | ○ | 30 | 0.07 |

| | Silver-plating coating film | | | | | Evaluation results of silver-plated member | | | |
|---|---|---|---|---|---|---|---|---|---|
| | Thickness of silver-plating coating film | Preferential orientation plane | Orientation proportion of {110} plane | Orientation ratio {110} / {311} | Crystallite size | Vickers hardness | Bending workability R = 1 mm | Durability in sliding test | Reflection density |
| | [μm] | | [%] | | [Å] | | | [times] | |
| Comp. Ex. 2 | 5 | {111} | 6.9 | 0.3 | 314.8 | 118.3 | ○ | 30 | 1.51 |
| Comp. Ex. 3 | 5 | {110} | 78.3 | 11.5 | 428.2 | 125.4 | ○ | 30 | 0.15 |
| Comp. Ex. 4 | 5 | {111} | 9.8 | 0.5 | 320.3 | 129.0 | × | 70 | 1.56 |
| Comp. Ex. 5 | 5 | {110} | 81.1 | 7.0 | 502.1 | 109.7 | ○ | 30 | 0.04 |
| Comp. Ex. 6 | 5 | {110} | 76.2 | 4.6 | 436.6 | 110.3 | ○ | 30 | 0.16 |
| Comp. Ex. 7 | 5 | {100} | 0.0 | 0.0 | 846.9 | 89.7 | ○ | 30 | 1.34 |
| Comp. Ex. 8 | 5 | {111} | 7.9 | 0.3 | 281.4 | 125.9 | × | 50 | 1.56 |
| Comp. Ex. 9 | 5 | {110} | 80.5 | 6.7 | 310.9 | 117.5 | × | 30 | 0.27 |

**Claims**

1. A silver-plated member with a surface layer made of a silver-plating layer being formed on a base member,

   wherein a crystal plane of the surface layer has a { 110} plane preferential orientation, and
   the orientation proportion of the { 110} plane is 30% or more and 75% or less.

2. The silver-plated member according to claim 1,
   wherein the base member is made of copper or a copper alloy.

3. The silver-plated member according to claim 1 or 2,
   wherein an underlying layer made of nickel is formed between the base member and the surface layer.

4. The silver-plated member according to any one of claims 1 to 3,
   wherein the surface layer has an average crystallite size of 45 nm or more.

5. The silver-plated member according to any one of claims 1 to 4,
   wherein the silver-plated member has a Vickers hardness HV of 100 or more.

6. The silver-plated member,
   wherein the surface layer has an orientation ratio {110} / {311} of the {110} plane to the {311} plane of 1.3 or more and 4.5 or less.

7. A method for producing a silver-plated member, the method comprising:
   forming a surface layer made of silver on a base member by performing electroplating in a silver plating solution made of an aqueous solution containing potassium silver cyanide at a concentration of 100 g/L or more and 160 g/L or less, potassium cyanide at a concentration 50 g/L or more and 130 g/L or less, and selenium at a concentration 20 mg/L or more and 50 mg/L or less at a current density of 1 A/dm$^2$ or more and 10 A/dm$^2$ or less and with a value obtained by dividing the concentration (g/L) of potassium silver cyanide by the current density (A/dm$^2$) being set to 25 (g·dm$^2$) / (L·A) or more and 80 (g·dm$^2$) / (L·A) or less.

8. The method for producing a silver-plated member according to claim 7,
   wherein the base member is made of copper or a copper alloy.

9. The method for producing a silver-plated member according to claim 7 or 8,
   wherein an underlying nickel plating layer is formed on the base member before the silver plating is performed.

10. The method for producing a silver-plated member according to any one of claims 7 to 9,
    wherein the silver plating solution contains potassium selenocyanate.

11. The method for producing a silver-plated member according to any one of claims 6 to 10,
    wherein the plating solution has a liquid temperature of 15°C or more and 40°C or less.

12. A terminal component in which the silver-plated member according to any one of claims 1 to 6 is used as a material.

## INTERNATIONAL SEARCH REPORT

| International application No. |
| --- |
| PCT/JP2020/047671 |

A. CLASSIFICATION OF SUBJECT MATTER
Int.Cl. C25D3/46(2006.01)i, C25D7/00(2006.01)i
FI: C25D7/00H, C25D3/46

According to International Patent Classification (IPC) or to both national classification and IPC

B. FIELDS SEARCHED

Minimum documentation searched (classification system followed by classification symbols)
Int.Cl. C25D3/46, C25D7/00

Documentation searched other than minimum documentation to the extent that such documents are included in the fields searched

| | |
| --- | --- |
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | WO 2015/068825 A1 (DOWA METALTECH KK) 14 May 2015 (2015-05-14), page 4, line 22 to page 7, line 9, page 26, line 12 to page 32, last line | 1–12 |
| A | JP 2013-76127 A (DOWA METALTECH KK) 25 April 2013 (2013-04-25), entire text, fig. 1–3 | 1–12 |
| A | JP 2013-189680 A (DOWA METALTECH KK) 26 September 2013 (2013-09-26), entire text, fig. 1–6 | 1–12 |

☐ Further documents are listed in the continuation of Box C.   ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 05 February 2021 | 22 February 2021 |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

INTERNATIONAL SEARCH REPORT
Information on patent family members

International application No.

PCT/JP2020/047671

| | | |
|---|---|---|
| WO 2015/068825 A1 | 14 May 2015 | US 2016/0265127 A1<br>paragraphs [0019]-[0032],<br>[0125]-[0131]<br>JP 2015-110833 A<br>EP 3078767 A<br>CN 105705680 A |
| JP 2013-76127 A | 25 April 2013 | US 2015/0243408 A1<br>entire text, fig. 1-3<br>WO 2013/047628 A1<br>EP 2749673 A1<br>CN 103917697 A |
| JP 2013-189680 A | 26 September 2013 | (Family: none) |

Form PCT/ISA/210 (patent family annex) (January 2015)

**EP 4 130 345 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009079250 A
- JP 2016204719 A
- JP 2014181391 A